# EUROPEAN PATENT APPLICATION

(11) **EP 4 345 873 A1**
(43) Date of publication of application: **03.04.2024**
(21) Application number: 22198708.4
(22) Date of filing: 29.09.2022
(51) Int. Cl.: H01L 21/78

(54) **WAFER COMPOSITE, SEMICONDUCTOR DEVICE AND METHODS OF MANUFACTURING A SEMICONDUCTOR CIRCUIT**

(71) Applicant: Infineon Technologies Austria AG, 9500 Villach (AT)
(72) Inventor: GRUBER, Hermann, 93086 Woerth a. D. (DE); BUSCH, Joerg, 93049 Regensburg (DE); DEBIE, Derek, 94327 Bogen (DE); SCHMIDT, Matthias, 81735 München (DE); PORWOL, Daniel, 94315 Straubing (DE); FISCHER, Thomas, 93049 Regensburg (DE)
(74) Representative: Müller Hoffmann & Partner

(57) **Abstract**

A layer stack (130) is formed that includes a device layer (110) and an insulator layer (120). The device layer (110) includes electronic elements (315). The insulator layer (120) is adjacent to a back surface (112) of the device layer (110). A spacer disk (190) is adhesive bonded on the layer stack (130) on a side opposite the device layer (110). The spacer disk (190) and the layer stack (130) form a wafer composite (100). The wafer composite (100) is divided into a plurality of individual semiconductor chips (900), wherein each semiconductor chip (900) includes a portion of the layer stack (130) and a portion of the spacer disk (190).

## Description

### TECHNICAL FIELD

Examples of the present disclosure relate to methods of manufacturing a semiconductor circuit, in particular SOI devices. The present disclosure also relates to a wafer composite including a semiconductor wafer and to a semiconductor device.

### BACKGROUND

The ongoing trend toward thinner silicon devices is driven in part by the need to reduce parasitic effects in a semiconductor bulk and save expensive semiconductor material. One of the technologies involved is silicon on insulator (SOI) technology, which concerns the fabrication of silicon semiconductor devices in a layered silicon-insulator-silicon substrate or in a layered silicon-insulator substrate. SOI-based devices differ from conventional devices made from a silicon layer without insulator base in that the active semiconductor layer is above an electrical insulator, usually silicon dioxide. A thinner semiconductor layer can reduce the parasitic capacitances and the amount of crystalline semiconductor material to be grown.

In the fabrication of semiconductor devices, especially thin semiconductor devices, there is a constant need for higher productivity and yield.

### SUMMARY

The need is satisfied with the subject-matter as defined in the independent claims.

An embodiment of the present disclosure relates to a method of manufacturing a semiconductor device. A layer stack is formed that includes a device layer and an insulator layer. The device layer includes electronic elements. The insulator layer is adjacent to a back surface of the device layer. A spacer disk is adhesive bonded on the layer stack on a side opposite the device layer. The spacer disk and the layer stack form a wafer composite. The wafer composite is divided into a plurality of individual semiconductor chips, wherein each semiconductor chip includes a portion of the layer stack and a portion of the spacer disk.

Another embodiment of the present disclosure relates to another method of manufacturing a semiconductor device. A wafer composite is provided, wherein the wafer composite includes a layer stack, an adhesive tape, and a spacer disk on a side of the adhesive tape opposite the layer stack. The layer stack includes at least a device layer and an insulator layer in contact with the device layer. Electronic elements are formed in the device layer. The adhesive tape is on a side of the layer stack opposite the device layer. The wafer composite is diced into a plurality of individual semiconductor chips, wherein each semiconductor chip includes a portion of the layer stack and a portion of the spacer disk.

A further embodiment of the present disclosure relates to a further method of manufacturing a semiconductor device. A semiconductor chip is provided. The semiconductor chip includes a device layer portion, an insulator layer portion in contact with a back surface of the device layer portion, an adhesive layer formed on a side of the insulator layer portion opposite the device layer portion, and a spacer layer formed on a side of the adhesive layer opposite the insulator layer portion. Electronic elements are formed in the device layer portion. Contact pads are formed on a contact side surface of the device layer portion. Electrical connections are formed between the contact pads and device terminals.

Another embodiment of the present disclosure relates to a wafer composite. A layer stack includes a device layer and an insulator layer, wherein the device layer includes electronic elements, and wherein the insulator layer is in contact with a back surface of the device layer. An adhesive tape is on a side of the layer stack opposite the device layer. A spacer disk is on a side of the adhesive tape opposite the insulator layer, wherein lateral shape and dimension of the spacer disk and the layer stack are identical.

Another embodiment of the present disclosure relates to a semiconductor device with a device layer portion including electronic elements. A contact pad is formed on a contact side surface of the device layer portion. An insulator layer portion is in contact with a back surface of the device layer portion. An adhesive layer is on a side of the insulator layer portion opposite the device layer portion. A spacer layer is on a side of the adhesive layer opposite the insulator layer portion.

Those skilled in the art will recognize additional features and advantages upon reading the following detailed description and on viewing the accompanying drawings.

### BRIEF DESCRIPTION OF THE DRAWINGS

The accompanying drawings are included to provide a further understanding of the embodiments and are incorporated in and constitute a part of this specification. The drawings illustrate embodiments of a wafer composite, a semiconductor device and a method of manufacturing a semiconductor circuit, and together with the description serve to explain principles of the embodiments. The drawings are not scaled and are for illustrative purposes only. Corresponding elements are designated by the same reference signs in the different drawings if not stated otherwise.

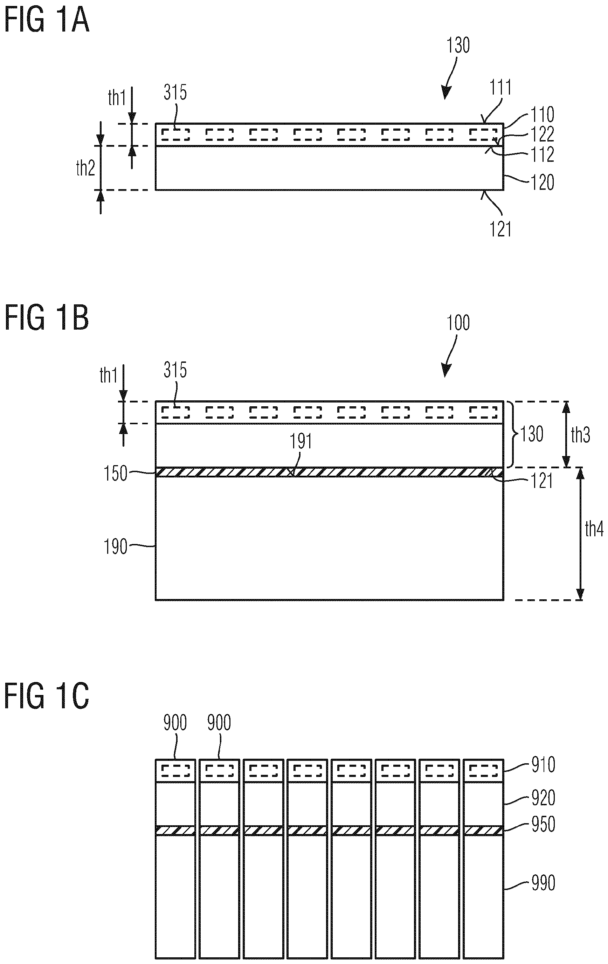

FIGS. 1A to 1C show schematic vertical cross-sectional views of a layer stack and a wafer composite including the layer stack before and after dividing the wafer composite into a plurality of semiconductor chips for illustrating a method of manufacturing a semiconductor circuit with a spacer layer according to an embodiment.

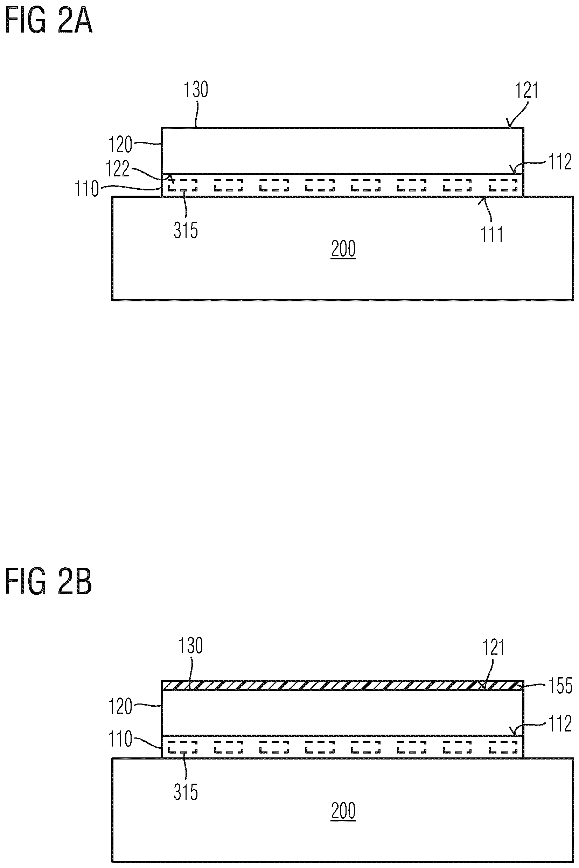

FIGS. 2A to 2D show schematic vertical cross-sectional views of a layer stack and a wafer composite including the layer stack before applying and after removing a substrate carrier for illustrating a method of manufacturing a semiconductor circuit with a spacer layer according to an embodiment using a substrate carrier.

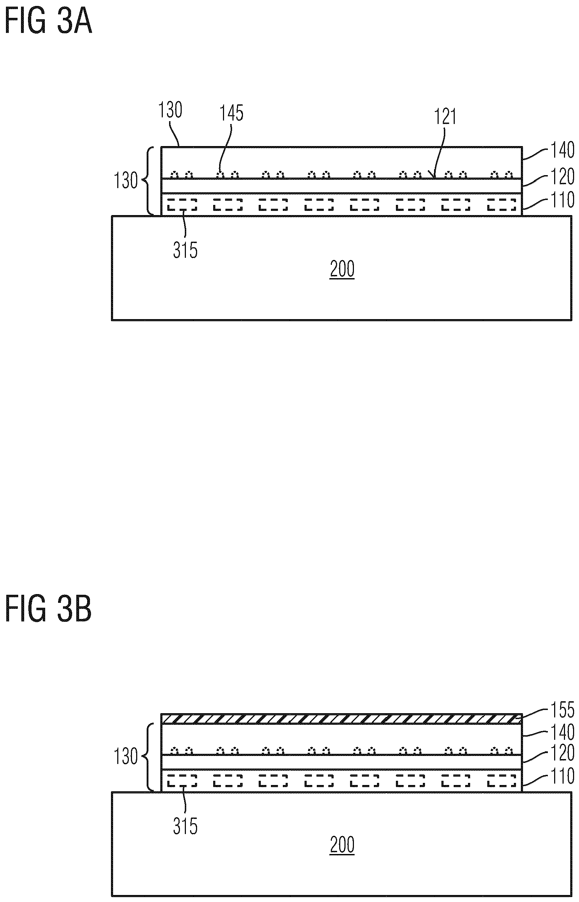

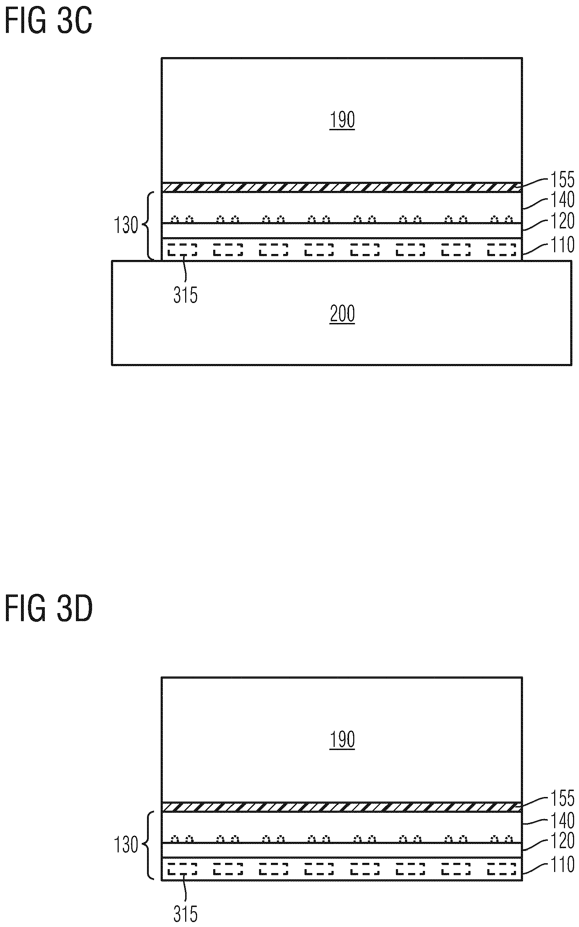

FIGS. 3A to 3D show schematic vertical cross-sectional views of a layer stack including a further semiconductor layer, and a wafer composite including the layer stack before applying and after removing a substrate carrier for illustrating a method of manufacturing a semiconductor circuit with a spacer layer according to another embodiment.

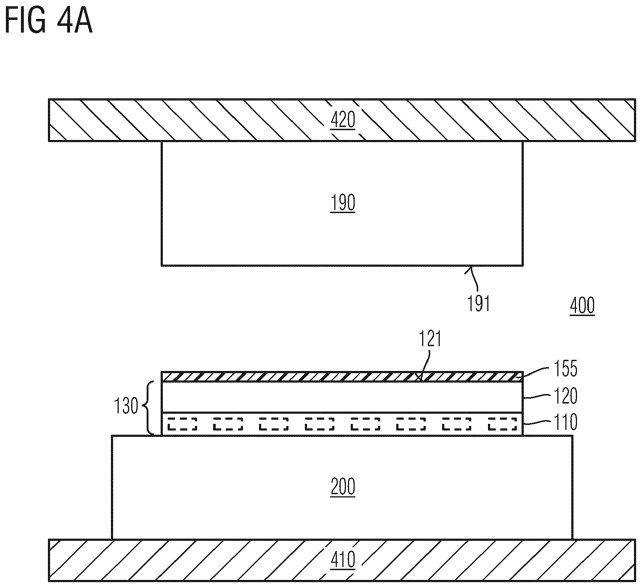

FIGS. 4A to 4B show schematic vertical cross-sectional views of a layer stack and a spacer disk before and after attaching the spacer disk to the layer stack for illustrating a method of manufacturing a semiconductor circuit with a spacer layer according to an embodiment using compressive force for attaching the spacer layer to the layer stack.

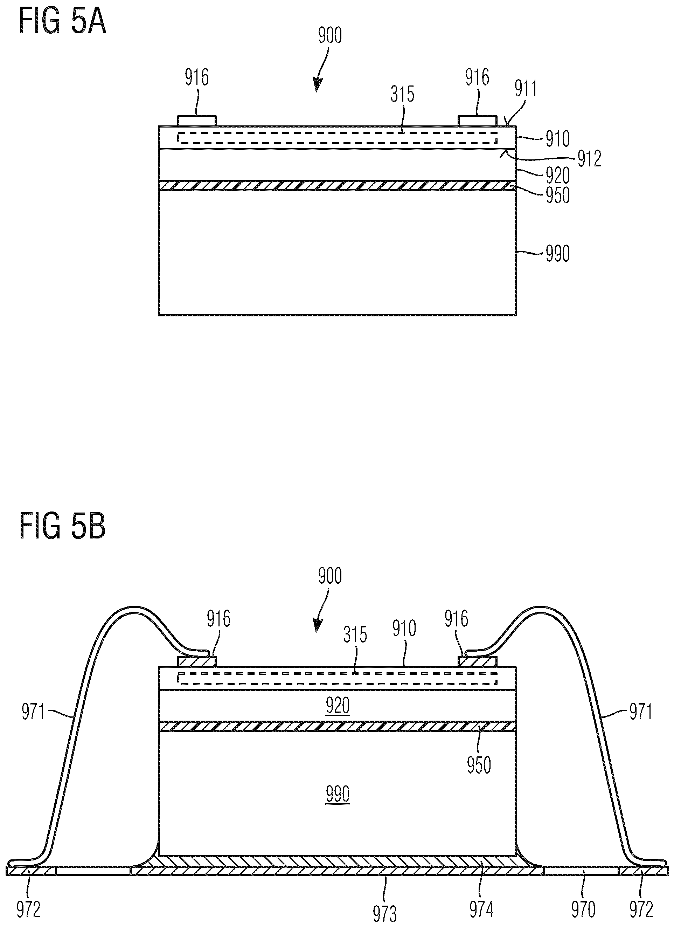

FIGS. 5A to 5C show schematic vertical cross-sectional views of a semiconductor chip and a semiconductor device with a spacer layer before, during and after packaging for illustrating a method of manufacturing a semiconductor circuit with a spacer layer according to another embodiment.

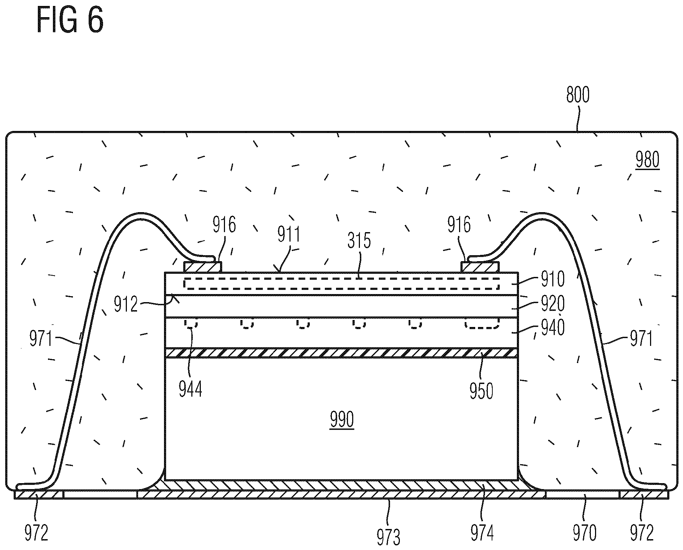

FIG. 6 shows a schematic vertical cross-sectional view of a semiconductor device with a spacer layer according to a further embodiment.

### DETAILED DESCRIPTION

In the following detailed description, reference is made to the accompanying drawings, which form a part hereof and in which are shown by way of illustrations specific embodiments in which a wafer composite, a semiconductor device and methods of manufacturing a semiconductor device may be practiced. It is to be understood that other embodiments may be utilized and structural or logical changes may be made without departing from the scope of the present disclosure. For example, features illustrated or described for one embodiment can be used on or in conjunction with other embodiments to yield yet a further embodiment. It is intended that the present disclosure includes such modifications and variations. The examples are described using specific language, which should not be construed as limiting the scope of the appending claims.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive ohmic connection between electrically connected elements, for example a direct contact between the concerned elements or a low-resistive connection via a metal and/or heavily doped semiconductor material.

Ranges given for physical dimensions include the boundary values. For example, a range for a parameter y from a to b reads as a ≤ y ≤ b. The same holds for ranges with one boundary value like "at most" and "at least".

The term "on" is not to be construed as meaning only "directly on". Rather, if one element is positioned "on" another element (e.g., a layer is "on" another layer or "on" a substrate), a further component (e.g., a further layer) may be positioned between the two elements (e.g., a further layer may be positioned between a layer and a substrate if the layer is "on" said substrate).

In the context of layers and layered structures, the preposition "opposite" is used to denote an arrangement on opposite major surfaces of a layer. For example, a horizontal layer A formed on a side of a horizontal layer X opposite a horizontal layer B is separated from layer B by layer X in the vertical direction.

A method of manufacturing a semiconductor device according to the present disclosure may include forming a layer stack that includes a device layer and an insulator layer. The device layer includes electronic elements. The insulator layer is adjacent to a back surface of the device layer. A spacer disk is adhered (adhesive bonded) on the layer stack on a side opposite the device layer, wherein the spacer disk and the layer stack form a wafer composite. The wafer composite is divided into a plurality of individual semiconductor chips (dies), wherein each semiconductor chip includes a portion of the layer stack and a portion of the spacer disk.

The device layer is based on a single-crystalline semiconductor material and includes doped regions that form semiconducting portions of the electronic elements. The semiconductor material may be an elemental semiconductor such as silicon or germanium or a compound semiconductor, for example, an IV/IV compound semiconductor such as silicon germanium SiGe or silicon carbide SiC, or an III/V compound semiconductor such as gallium arsenide GaAs or gallium nitride GaN. The device layer may include other materials, for example, insulator materials such as silicon oxides, silicon nitrides, and/or doped or undoped glasses, and/or highly conductive materials such as doped polycrystalline silicon, elemental metals, metal compounds and/or metal alloys. The electronic elements may include semiconductor elements such as diodes, bipolar junction transistors (BJTs), insulated gate field effect transistors (IGFETs), junction field effect transistors (JFETs) and/or insulated gate bipolar transistors (IGBTs). For example, the electronic elements may be elements of a gate driver circuit, a power factor correction circuit, a motor control circuit, a wireless charging circuit, a high frequency switch, and/or a logic circuit.

The device layer has a substantially planar front surface (device layer front surface) in a horizontal plane, wherein at least some doped regions of the electronic elements extend form the front surface into the device layer, and a substantially planar back surface (device layer back surface) opposite the device layer front surface. A normal to the device layer front surface defines a vertical direction.

The device layer front surface and the device layer back surface are at least approximately parallel to each other so that a thickness of the device layer between the device layer front surface and the device layer back surface is uniform.

The insulator layer may be a homogenous layer or a layer stack including two or more sublayers of different composition and/or internal structure (German: Gefüge). For example, the insulator layer may include a thermally grown silicon oxide layer, a deposited silicon oxide layer and/or a deposited silicon nitride layer. The insulator layer has a substantially planar front surface (insulator layer front surface) at a side averted from the device layer, and a substantially planar back surface (insulator layer back surface) oriented to the device layer. The insulator layer front surface and the insulator layer back surface are at least approximately parallel to each other so that a thickness of the insulator layer between the insulator layer front surface and the insulator layer back surface is at least approximately uniform. The insulator layer back surface may be in direct contact with the device layer back surface.

The spacer disk may be a solid or patterned disk. The material of the spacer disk may be homogenous. Alternatively, the spacer disk may include two or more vertically stacked layers of different composition and/or internal structure. For example, the spacer disk may consist of or may include a metal-containing layer, may consist of or may include a layer from a semiconductor material such as single crystalline silicon, or may consist of or may include an insulator layer, e.g. a glass, a ceramic or a resin, e.g. a high heat resistant plastic.

The spacer disk may be directly adhesive bonded onto the insulator layer front surface opposite the device layer. Alternatively, the layer stack may include a further semiconductor layer formed on the insulator layer front surface, wherein the spacer disk may be adhesive bonded to a side of the further semiconductor layer opposite the insulator layer.

Adhesive bonding the spacer disk onto the insulator layer may include applying an adhesive or glue to the insulator layer front surface and/or a mounting surface of the spacer disk (spacer disk mounting surface), and bringing the insulator layer front surface and the spacer disk mounting surface in contact with the adhesive therebetween. The adhesive may be applied, for example, in liquid form or as component of an adhesive tape. The adhesive may be conductive or nonconductive.

The spacer disk may be conductive or insulating, and apart from being insulating or conductive, the spacer disk may be devoid of any other electrical function. In particular, the spacer disk is devoid of active electronic elements. The spacer disk may have the same lateral shape and dimension as the layer stack. Adhesive bonding the spacer disk to the layer stack may be done at ambient temperature or at only a slightly elevated temperature below 200 degrees Celsius and/or with only moderate mechanical force, so that the spacer disk may be applied without subjecting the layer stack to critical conditions.

Dividing the wafer composite may include mechanical sawing, sawing by laser, chemical etching, and/or chemical-physical etching along first and second kerf streets, wherein the second kerf streets run orthogonal to the first kerf streets. The dividing process dices the wafer composite into a plurality of substantially identical semiconductor chips with rectangular horizontal cross-section.

By selecting an appropriate thickness of the spacer disk, the vertical expansion (thickness) of a wafer composite and the thickness of semiconductor chips fabricated from the wafer composite can be adjusted. In particular, wafer composites and semiconductor chips based on layer stacks having comparatively thin device layers and thin insulator layers can be made to have a thickness sufficient to ensure compatibility of the wafer composite and semiconductor chips with conventional test and packaging equipment for further processing of the semiconductor chips.

A thickness of the device layer may be at most 100µm, wherein a sum of a thickness of the layer stack and a thickness of the spacer disk is at least 100µm.

In particular, for SOI devices based on an insulator layer formed by deposition and/or thermal oxidation, the device layer may have a thickness of less than 1µm, e.g. less than 100nm, or less than 50nm, and the insulator layer may have a thickness of less than 50pm, e.g. less than 10µm, so that the total thickness of the layer stack may be less than a few micrometers. On the other hand, many tools for assembly, test and packaging are designed for a wafer thickness or chip thickness of at least 100µm, 200µm, or 500µm. The spacer disk facilitates the use of conventional tools for assembly, test and packaging without refitting (conversion).

Adhesive bonding the spacer disk on the layer stack may include applying an adhesive tape to the layer stack on the side opposite the device layer, wherein the adhesive tape may include a partially crosslinked resin.

The resin is not fully cross-linked but partially crosslinked to the extent that the resin does not flow at room temperature. In particular, the resin may be crosslinked to the extent that the resin just does not flow at room temperature.

Unlike liquid adhesives, the partially crosslinked resin on the adhesive tape is inherently applied with high conformity, so the mounting surfaces of the spacer disk and the layer stack on both sides of the adhesive tape are highly parallel to each other with little effort, improving compatibility with existing tools for assembly, test and packaging.

Adhesive bonding the spacer disk on the layer stack may further include attaching the spacer layer to the adhesive tape on a side of the adhesive tape opposite the layer stack.

The adhesive tape may be applied to the layer stack first, and then the spacer disk may be attached to the adhesive tape on the side opposite the layer stack. Alternatively, the spacer disk may be attached to the adhesive tape first, and then the layer stack may be applied to the adhesive tape on the side opposite the spacer disk. Alternatively, the spacer disk and the layer stack may be simultaneously attached onto opposite sides of the adhesive tape.

Applying the adhesive tape on the layer stack and/or on the spacer disk may use proven and tested laminating processes for wafers, e.g. for applying a die-attach-foil, wherein a prefabricated piece of foil that may have the lateral dimensions of the wafer composite is prepared and bonded to the layer stack.

Adhesive bonding the spacer disk on the insulator layer may further include curing the partially crosslinked resin after applying the adhesive tape on the insulator layer and after attaching the spacer disk to the adhesive tape.

After the curing, the resin that was originally only partially crosslinked is crosslinked to a higher degree than before. For example, after the curing the resin may be fully crosslinked or at least 80% crosslinked. The curing may include one single heating with or without applying compressive stress on the adhesive type. The heating may be provided for the only reason of curing the adhesive. Alternatively, the curing is a side effect of another manufacturing step or other manufacturing steps applied to the wafer composite and/or a semiconductor chip obtained from the wafer composite prior to an end of a packaging process that encapsulates in a mold a semiconductor chip obtained from the wafer composite.

Curing the partially crosslinked resin may include exerting compressive stress on the partially crosslinked resin.

For example, a first bonding apparatus may laminate the adhesive tape onto the layer stack mounting surface first, and then the first bonding apparatus or a second bonding apparatus may press the spacer disk onto a side of the adhesive tape opposite the layer stack to generate a sufficient bonding force. Alternatively, the first bonding apparatus may laminate the adhesive tape onto the spacer disk mounting surface first, and then the first or the second bonding apparatus may press the layer stack onto a side of the adhesive tape opposite the spacer disk to generate a sufficient bonding force.

Forming the layer stack may include depositing and/or thermally growing the insulator layer on a back surface of the device layer after forming the electronic circuits in the device layer.

The method may further include attaching a substrate carrier to the device layer prior to thinning the device layer or prior to forming the insulator layer, and removing the substrate carrier at the earliest after adhesive bonding the spacer disk to the insulator layer.

The substrate carrier may be a solid or patterned disk. The material of the substrate carrier may be homogenous. Alternatively, the substrate carrier may include two or more vertically stacked layers of different composition and/or internal structure. For example, the substrate carrier may consist of or may include a metal-containing layer, may consist of or may include a layer from a semiconductor material such as single crystalline or polycrystalline silicon, or may consist of or may include an insulator layer, e.g. a glass or an insulating ceramic. The substrate carrier may mechanically stabilize the thin device layer during formation of the insulator layer and/or may mechanically stabilize the layer stack for the process of adhesive bonding the spacer disk to the layer stack.

Another method of manufacturing a semiconductor circuit may include providing a wafer composite, wherein the wafer composite includes a layer stack, an adhesive tape, and a spacer disk on a side of the adhesive tape opposite the layer stack. The layer stack may include at least a device layer and an insulator layer in contact with the device layer. Electronic elements may be formed in the device layer. The adhesive tape is on a side of the layer stack opposite the device layer. The method may further include dicing the wafer composite into a plurality of individual semiconductor chips, wherein each semiconductor chip includes a portion of the layer stack and a portion of the spacer disk.

A further method of manufacturing a semiconductor device may include providing a semiconductor chip, wherein the semiconductor chip may include a device layer portion, an insulator layer portion in contact with a back surface of the device layer portion, an adhesive layer formed on a side of the insulator layer portion opposite the device layer portion, and a spacer layer formed on a side of the adhesive layer opposite the insulator layer portion. Electronic elements may be formed in the device layer portion. Contact pads are formed on a contact side surface of the device layer portion. The method may further include forming electrical connections between the contact pads and device terminals.

The adhesive layer may be in direct contact with a surface of the insulator layer portion opposite the device layer portion. Alternatively, the semiconductor chip may include a substrate layer formed on the insulator layer portion, wherein the adhesive layer may be in direct contact with a surface of the substrate layer opposite the insulator layer portion.

Forming the electrical connection may include a step of wire bonding, wherein bond wires are formed between the contact pads and the device terminals.

Another embodiment refers to a wafer composite. The wafer composite may include a layer stack, an adhesive tape and a spacer disk. The layer stack includes a device layer and an insulator layer, wherein the device layer includes electronic elements, and wherein the insulator layer is in contact with a back surface of the device layer. An adhesive tape is located on a side of the layer stack opposite the device layer. The spacer disk is on a side of the adhesive tape opposite the insulator layer, wherein lateral shape and dimension of the spacer disk and the layer stack may be identical.

A thickness of the spacer disk is less than 1mm, e.g. less than 800µm. The spacer disk is formed to be permanently in structural connection with the layer stack. The adhesive tape provides a permanent connection between the layer stack and the spacer disk.

A thickness of the device layer may be at most 100µm, wherein a sum of a thickness of the layer stack and a thickness of the spacer disk may be at least 100µm.

For example, a thickness of the device layer may be at most 10µm, 1µm, 100nm or 50nm. A sum of the thickness of the layer stack and the thickness of the spacer disk may be at least 200pm.

Another embodiment relates to a semiconductor device that may include a device layer portion, an insulator layer portion, an adhesive layer, and a spacer layer. The device layer portion may include electronic elements and a contact pad formed on a contact side surface of the device layer portion. The insulator layer portion is in contact with a back surface of the device layer portion. The adhesive layer is on a side of the insulator layer portion opposite the device layer portion. The spacer layer is on a side of the adhesive layer opposite the insulator layer portion.

The adhesive layer may be in direct contact with a surface of the insulator layer portion opposite the device layer portion. Alternatively, the semiconductor chip may include a substrate layer formed on a side of the insulator layer portion opposite the device layer portion, wherein the adhesive layer may be in direct contact with a surface of the substrate layer opposite the insulator layer portion.

The adhesive layer may be a homogenous layer containing a fully or almost fully cross-linked resin. Alternatively, the adhesive layer may include a carrier tape, a first adhesive layer between the carrier tape and the insulator layer portion and a second adhesive layer between the carrier type and the spacer layer. The first and second adhesive layers may be homogenous layers containing a fully or almost fully cross-linked resin.

A thickness of the device layer portion may be at most 100µm, e.g. at most 10µm, or 1µm. A sum of the thickness of the device layer portion, a thickness of the insulator layer portion and a thickness of the spacer layer may be at least 100µm, e.g. at least 200µm.

The semiconductor device may further include a device terminal and a wiring connection between the contact pad and the device terminal. The wiring connection provides a direct electrical connection between a contact pad and a device terminal.

FIG. 1A to 1C illustrate a method of manufacturing a semiconductor device with a spacer layer.

FIG. 1A shows a layer stack 130 including a device layer 110 and an insulator layer 120.

The device layer 110 is made of a single-crystalline semiconductor material and includes doped regions of electronic elements 315. The electronic elements 315 include diodes, bipolar transistors, insulated gate field effect transistors, junction field effect transistors and/or insulated gate bipolar transistors, and form elements of a gate driver circuit, a power factor correction circuit, a motor control circuit, a wireless charging circuit, a high frequency switch, or a logic circuit.

The device layer 110 has a planar front surface 111 (device layer front surface 111), from which at least some of the doped regions of the electronic elements 315 extend into the device layer 110, and a planar back surface 112 (device layer back surface 112). The device layer front surface 111 and the device layer back surface 112 run parallel to each other. A thickness th1 of the device layer 110 between the device layer front surface 111 and the device layer back surface 112 is at most 1µm, at most 100nm, or at most 50nm.

The insulator layer 120 is a silicon oxide layer that includes a thermally grown silicon oxide layer and/or a deposited silicon oxide layer. The insulator layer 120 has a planar front surface 121 (insulator layer front surface 121) and a planar back surface 122 (insulator layer back surface 122). The insulator layer front surface 121 and the insulator layer back surface 122 are parallel to each other. A thickness th2 of the insulator layer 120 between the insulator layer front surface 121 and the insulator layer back surface 122 is at most 50µm, or at most 10µm. The insulator layer back surface 122 is in direct contact with the device layer back surface 112.

A spacer disk 190 is adhesive bonded onto the insulator layer front surface 121 at a side of the layer stack 130 opposite the device layer 110.

The spacer disk 190 is a solid disk. The spacer disk 190 may be homogenous or may include two or more vertically stacked layers of different composition and/or internal structure. The spacer disk 190 may consist of or may include a metal-containing layer, may consist of or may include a layer from a semiconductor material, or may consist of or may include an insulator layer, e.g. a glass, a ceramic or a resin, e.g., a high heat resistant plastic.

The spacer disk 190 is conductive or insulating, and apart from being insulating or conductive, the spacer disk 190 is devoid of any other electrical function. In particular, the spacer disk is devoid of active electronic elements. The spacer disk 190 has the same lateral shape and lateral dimension as the layer stack 130.

Adhesive bonding the spacer disk 190 to the layer stack 130 includes applying an adhesive 150 onto the insulator layer front surface 121 and/or on a mounting surface 191 of the spacer disk 190, and then bringing the mounting surface 191 of the spacer disk 190 in contact with the adhesive 150 on the insulator layer front surface 121. Adhesive bonding may include curing the adhesive 150 present between the insulator layer front surface 121 and the spacer disk 190.

FIG. 1B shows a wafer composite 100 obtained by adhesive-bonding the spacer disk 190 onto the front surface 121 of the insulator layer 120 of FIG. 1A. The cured adhesive 150 mechanically connects the layer stack 130 and the spacer disk 190.

The wafer composite 100 is divided (diced) into a plurality of individual semiconductor chips 900. Dividing the wafer composite 100 may include mechanical sawing, sawing by laser, chemical etching, and/or chemical-physical etching along first and second kerf streets, wherein the second kerf streets run orthogonal to the first kerf streets.

FIG. 1C shows semiconductor chips 900 obtained by dicing the wafer composite 100 of FIG. 1B.

The dividing process dices the wafer composite 100 into a plurality of identical semiconductor chips 900 with rectangular horizontal cross-section. Each semiconductor chip 900 includes a device layer portion 910 that includes a portion of the device layer 110, an insulator layer portion 920 that includes a portion of the insulator layer 120, an adhesive layer 950 that includes a portion of the cured adhesive 150, and a spacer layer 990 formed from a portion of the spacer disk 190 of FIG. 1B.

By selecting an appropriate thickness of the spacer disk 190, a thickness of the wafer composite 100 and a thickness of the semiconductor chips 900 can be adjusted to ensure compatibility of the wafer composite 100 and semiconductor chips 900 with conventional test and packaging equipment for further processing of the semiconductor chips 900.

FIG. 2A to 2D illustrate a method of manufacturing a semiconductor device with a spacer layer, wherein an adhesive tape 155 is used to structurally connect a layer stack 130 with a spacer disk 190.

A layer stack 130 including a device layer 110 and an insulator layer 120 as described above is mounted on a top surface of a substrate carrier 200, wherein the device layer front surface 111 is oriented to the substrate carrier 200. For example, the device layer 110 is bonded with the device layer front surface 111 onto the top surface of the substrate carrier 200, wherein the bond may be a glue-less bond or an adhesive bond. Alternatively, the layer stack 130 may be electrostatically or pneumatically chucked on the top surface of the substrate carrier 200.

The substrate carrier 200 may be attached to the device layer 110 prior to a thinning of the device layer 110 or prior to forming the insulator layer 120.

The illustrated substrate carrier 200 is a solid, homogenous disk of a metal-containing material, a semiconductor material, or an insulating material. The substrate carrier 200 mechanically may stabilize the thin device layer 110 during formation of the insulator layer 120 and/or may stabilize the layer stack 130 for the process of adhesive bonding the spacer disk 190 to the layer stack 130.

FIG. 2A shows the layer stack 130 including a device layer 110 and an insulator layer 120 as described above mounted on the top surface of the substrate carrier 200. The substrate carrier 200 may be a plate with planar top surface, wherein a lateral extension of the top surface is greater than a lateral extension of the layer stack. Alternatively, the substrate carrier may be part of a chuck.

An adhesive tape 155 is applied onto an exposed front surface 121 of the insulator layer 120 averted from the substrate carrier 200. Applying the adhesive tape 155 on the layer stack 130 includes proven and tested laminating processes for wafers, wherein a prefabricated piece of foil with the lateral dimensions of the layer stack 130 is prepared and adhesive bonded to the layer stack 130.

FIG. 2B shows the adhesive tape 155 on the front surface 121 of the insulator layer 120. The adhesive tape 155 may include a carrier tape, a first adhesive layer formed on a first side of the carrier tape, and a second adhesive layer formed on an opposite second side of the carrier tape. The adhesive layers may contain a resin that may be partially cured to an extent so that the resin is fixed on the carrier tape at 25 degree Celsius. The thickness of the adhesive type 155 is highly uniform. Unlike liquid adhesives, the partially crosslinked resin on the adhesive tape 155 is inherently applied with high conformity, allowing mounting surfaces of the spacer disk 190 and the layer stack 130 on both sides of the adhesive tape 155 to be highly parallel to each other with little effort, improving compatibility with existing tools for assembly, test and packaging.

A spacer disk 190 is brought into contact with the exposed side of the adhesive tape 155.

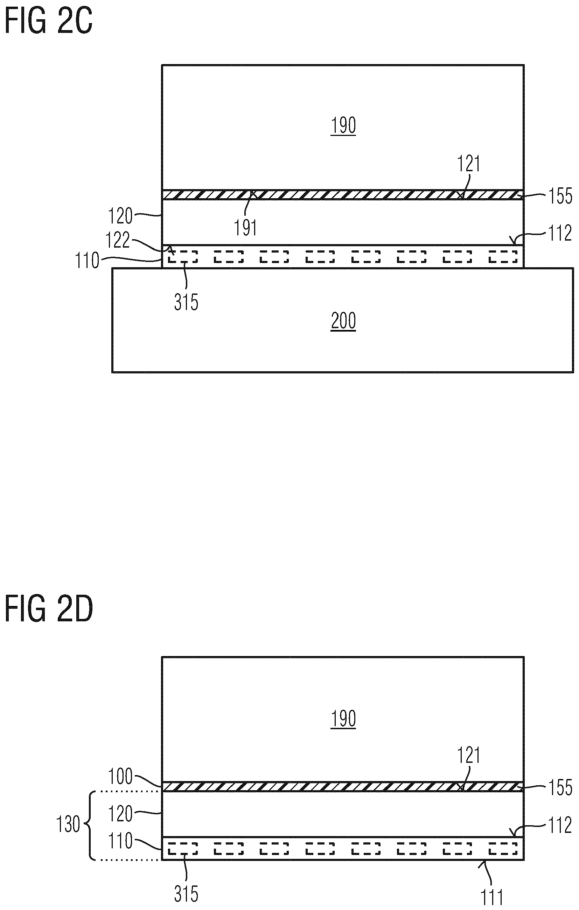

FIG. 2C shows the spacer disk 190 and the insulator layer 120 attached to opposite sides of the intervening adhesive tape 155. Due to the very uniform thickness of the adhesive tape 155, the mounting surface 191 of the spacer disk 190 and the insulator layer front surface 121 on opposite sides of the adhesive tape 155 are aligned substantially parallel to each other.

A heating cures the adhesive in the adhesive layers such that after the heating the adhesive is cross-linked to a greater extent than before. The heating may fully or almost fully cross-link the adhesive, e.g., resin. The heating may be a single heating process or may include several heating steps. The heating may start at the earliest after the spacer disk 190 has been brought into contact with the adhesive tape 155 and may be completed before the packaged semiconductor device is shipped, e.g., before the substrate carrier 200 is removed or before the wafer composite 100 is diced.

FIG. 2D shows the wafer composite 100 after detaching the wafer composite 100 from the substrate carrier. Alternatively, the substrate carrier 200 may be used during the dicing process and removed only after dividing the wafer composite 100 into individual semiconductor chips.

The wafer composite 100 includes a layer stack 130, an adhesive tape 155 and a spacer disk 190. The layer stack 130 includes a device layer 110 and an insulator layer 120. Electronic elements 315 are formed in and/or on the device layer 110. The insulator layer 120 is in contact with a back surface 112 of the device layer 110. The adhesive tape 155 is located on a side of the layer stack 130 opposite the device layer 110, wherein the adhesive tape 155 is in direct contact with the insulator layer 120. The adhesive tape 155 contains fully or almost fully cross-linked adhesive, e.g., resin. The spacer disk 190 is on a side of the adhesive tape 155 opposite the insulator layer 120, wherein lateral shape and dimension of the spacer disk 190 and the layer stack 130 are identical.

A thickness of the device layer 110 may be at most 100µm, wherein a sum of a thickness th3 of the layer stack 130 and a thickness of the spacer disk 190 is at least 100µm.

FIG. 3A to 3D illustrate a method of manufacturing a semiconductor device that includes a substrate layer between the insulator layer portion and the spacer layer.

The layer stack 130 in FIG. 3A differs from the layer stack 130 in FIG. 2A in that the layer stack 130 includes a further semiconductor layer 140 formed on the insulator layer front surface 121. The further semiconductor layer 140 may have a background doping of a first conductivity type. Doped regions 145 of an opposite second conductivity may extend from a side oriented to the insulator layer front surface 121 into the further semiconductor layer 140. The first conductivity type may be n-type, and the second conductivity type may be p-type. A thickness of the further semiconductor layer 140 may be less than 10µm.

As illustrated in FIG. 3B, an adhesive tape 155 is bonded to a side of the further semiconductor layer 140 opposite the insulator layer 120.

FIG. 3C shows the adhesive tape 155 adhesive bonding the spacer disk 190 to the further semiconductor layer 140.

FIG. 3D shows a wafer composite 100 that differs from the wafer composite 100 illustrated in FIG. 2D in that the layer stack 130 includes the further semiconductor layer 140 formed on a side of the insulator layer 120 opposite the device layer 110, in that the adhesive tape 155 is in direct contact with the further semiconductor layer 140, and in that the spacer disk 190 is adhesive bonded to a side of the further semiconductor layer 140 opposite the insulator layer 120.

FIG. 4A to FIG. 4B refer to a method in which a bonding apparatus 400 applies compressive stress to the partially crosslinked resin in an adhesive tape 155 to cure the resin.

FIG. 4A shows an adhesive tape 155 laminated onto the insulator layer front surface 121 of a layer stack 130 as described with reference to FIG. 2B. A composite including the adhesive tape 155, the layer stack 130 and the substrate carrier 200 is placed and detachably fixed, e.g. electrostatically or pneumatically chucked, on a first plate 410 of the bonding apparatus 400. The spacer disk 190 is placed and detachably fixed, e.g. electrostatically or pneumatically chucked, on a second plate 420 of the bonding apparatus 400.

The first plate 410 and the second plate 420 are aligned to each other such that a mounting surface 191 of the spacer disk 190 and the insulator layer front surface 121 are parallel to each other and the spacer disk 190 is laterally adjusted to the layer stack 130.

The bonding apparatus 400 moves the first plate 410 and/or the second plate 420 toward each other in a vertical direction, pressing the spacer disk 190 onto the adhesive tape 155 to create sufficient bonding force.

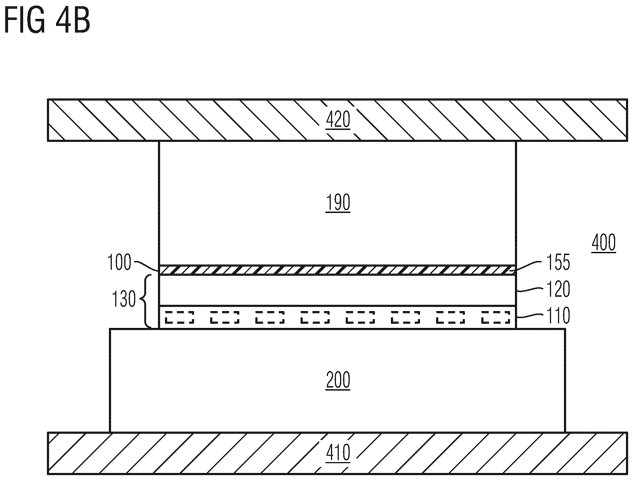

FIG. 4B shows the first plate 410 and the second plate 420 in a position where the spacer disk 190 is pressed onto the adhesive tape 155. The bonding may include a heating of the wafer composite 100 including the spacer disk 190, the adhesive tape 155, and the layer stack 130 in the state shown in FIG. 4B and/or later, e.g. outside the bonding apparatus 400.

FIG. 5A to 5C illustrate a method of manufacturing a semiconductor device 800 from a wafer composite 100 as illustrated in the previous FIGs.

A wafer composite 100 that includes a layer stack 130, an adhesive tape 155, and a spacer disk 190 on a side of the adhesive tape 155 opposite the layer stack 130 is divided into individual semiconductor chips 900, wherein the layer stack 130 includes a device layer 110 and an insulator layer 120 in contact with the device layer 110, wherein electronic elements 315 are formed in the device layer 110, and wherein the adhesive tape 155 is formed on a side of the layer stack 130 opposite the device layer 110, as illustrated in FIG. 1A.

FIG. 5A shows one of the semiconductor chips 900 obtained by dicing. The semiconductor chip 900 includes a device layer portion 910, an insulator layer portion 920 in contact with a back surface 912 of the device layer portion 910, an adhesive layer 950 formed on a side of the insulator layer portion 920 opposite the device layer portion 910, and a spacer layer 990 formed on a side of the adhesive layer 950 opposite the insulator layer portion 920. Electronic elements 315 are formed in the device layer portion 910. Contact pads 916 are formed on a contact side surface 911 of the device layer portion 910.

The semiconductor chip 900 is placed and bonded, e.g. adhesive bonded, onto a mounting side of a lead frame 970. Wiring connections 971 are formed between the contact pads 916 of the semiconductor chip 900 and device terminals 972 of the lead frame 970 by wire bonding.

FIG. 5B shows the semiconductor chip 900 mounted on the lead frame 970, wherein the spacer layer 990 is oriented to the mounting surface of the lead frame 970. Bond wires electrically connect the contact pads 916 with the device terminals 972. Glue and/or solder 974 fixes the semiconductor chip 900 on a mounting portion 973 of the lead frame 970.

A molding process encapsulates the semiconductor chip 900 and at least partly separates the device terminals 972 from each other to form a semiconductor device 800.

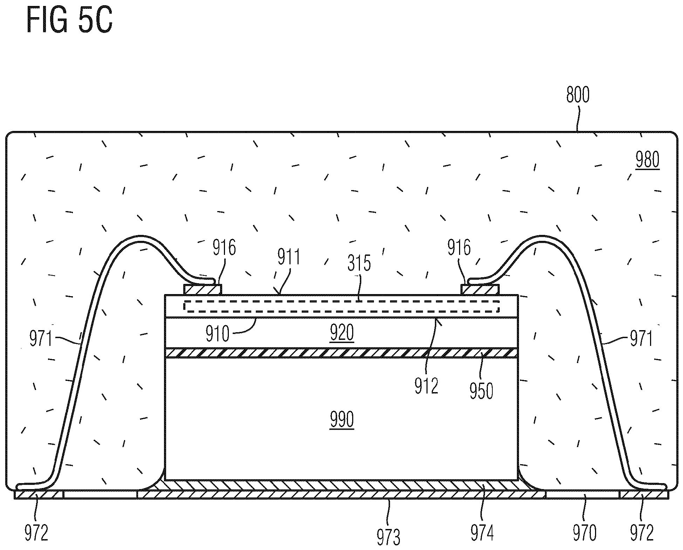

FIG. 5C shows the semiconductor device 800 that includes a device layer portion 910, an insulator layer portion 920, an adhesive layer 950, and a spacer layer 990. The device layer portion 910 may include electronic elements 315 and a contact pad 916 formed on a contact side surface 911 of the device layer portion 910. The insulator layer portion 920 is in contact with a back surface 912 of the device layer portion 910. The adhesive layer 950 is on a side of the insulator layer portion 920 opposite the device layer portion 910, and may be in direct contact with a surface of the insulator layer portion 920 opposite the device layer portion 910. The spacer layer 990 is on a side of the adhesive layer 950 opposite the insulator layer portion 920.

The adhesive layer 950 may include an adhesive tape. The adhesive tape may include a carrier tape, a first adhesive layer between the carrier tape and the insulator layer portion 920, and a second adhesive layer between the carrier tape and the spacer layer 990. The first and second adhesive layers include a fully or almost fully cross-linked resin.

A thickness of the device layer portion 910 may be at most 100µm, e.g. at most 10µm, or 1µm. A sum of the thickness of the device layer portion 910, a thickness of the insulator layer portion 920, a thickness of the adhesive layer 950 and a thickness of the spacer layer 990 is at least 100µm.

The semiconductor device 800 further includes device terminals 972 and wiring connections 971 between the contact pads 916 and the device terminals 972. A mold 980 encapsulates and seals the semiconductor chip 900 and the wiring connections 971 to protect the semiconductor chip 900 and the wiring connections from physical and chemical impacts, external humidity and contaminants. The material of the mold 980 may be a cured resin.

The semiconductor device 800 in FIG. 6 differs from the semiconductor device 800 in FIG. 5C in a semiconducting substrate layer 940 formed on the insulator layer portion 920. The substrate layer 940 has a background doping of a first conductivity type. Doped regions 945 of an opposite second conductivity may extend from a side oriented to the insulator layer portion 920 into the substrate layer 940. The first conductivity type may be n-type, and the second conductivity type may be p-type. A thickness of the substrate layer 940 may be less than 10µm. The adhesive layer 950 is in direct contact with a surface of the substrate layer 940 opposite the insulator layer portion 920.

## Claims

1. A method of manufacturing a semiconductor circuit, the method comprising:
forming a layer stack (130) comprising a device layer (110) and an insulator layer (120), wherein the device layer (110) comprises electronic elements (315), and wherein the insulator layer (120) is adjacent to a back surface (112) of the device layer (110);
adhesive bonding a spacer disk (190) on the layer stack (130) on a side opposite the device layer (110), wherein the spacer disk (190) and the layer stack (130) form a wafer composite (100); and
dividing the wafer composite (100) into a plurality of individual semiconductor chips (900), wherein each semiconductor chip (900) comprises a portion of the layer stack (130) and a portion of the spacer disk (190).

2. The method according to the preceding claim,
wherein a thickness th1 of the device layer (110) is at most 100µm, and wherein a sum of a thickness th3 of the layer stack (130) and a thickness th4 of the spacer disk (190) is at least 100µm.

3. The method according to any of the preceding claims,
wherein adhesive bonding the spacer disk (190) on the layer stack (130) comprises applying an adhesive tape (155) to the layer stack (130) on the side opposite the device layer (110), and wherein the adhesive tape (155) comprises a partially crosslinked resin.

4. The method according to the preceding claim,
wherein adhesive bonding the spacer disk (190) on the layer stack (130) further comprises attaching the spacer disk (190) to the adhesive tape (155) on a side of the adhesive tape (155) opposite the layer stack (130).

5. The method according to the preceding claim,
wherein adhesive bonding the spacer disk (190) on the insulator layer (120) further comprises curing the partially crosslinked resin after applying the adhesive tape on the insulator layer (120) and after attaching the spacer disk (190) to the adhesive tape (155).

6. The method according to the preceding claim,
wherein further curing the partially crosslinked resin further comprises exerting compressive stress on the partially crosslinked resin.

7. The method according to any of the preceding claims,
wherein forming the layer stack (130) comprises depositing and/or thermally growing the insulator layer (120) on a back surface of the device layer (110) after forming the electronic elements (315) in the device layer (110) .

8. The method according to any of the preceding claims, further comprising:
attaching a substrate carrier (200) to the device layer (110) prior to thinning the device layer (110) or prior to forming the insulator layer (120) and removing the substrate carrier (200) at the earliest after adhesive bonding the spacer disk (190) on the insulator layer (120).

9. A method of manufacturing a semiconductor circuit, the method comprising:
providing a wafer composite (100), wherein the wafer composite (100) comprises a layer stack (130), an adhesive tape (155), and a spacer disk (190) on a side of the adhesive tape (155) opposite the layer stack (130), wherein the layer stack (130) comprises at least a device layer (110) and an insulator layer (120) in contact with the device layer (110), wherein electronic elements (114) are formed in the device layer (110), and wherein the adhesive tape (155) is on a side of the layer stack (130) opposite the device layer (110); and
dicing the wafer composite (100) into a plurality of individual semiconductor chips (900), wherein each semiconductor chip (900) comprises a portion of the layer stack (130) and a portion of the spacer disk (190).

10. A method of manufacturing a semiconductor device, the method comprising:
providing a semiconductor chip (900), wherein the semiconductor chip (900) comprises a device layer portion (910), an insulator layer portion (920) in contact with a back surface (912) of the device layer portion (910), an adhesive layer (950) formed on a side of the insulator layer portion (920) opposite the device layer portion (910), and a spacer layer (990) formed on a side of the adhesive layer (950) opposite the insulator layer portion (920), wherein electronic elements (315) are formed in the device layer portion (910), and wherein contact pads (916) are formed on a contact side surface of the device layer portion (910); and
forming electrical connections between the contact pads (916) and device terminals (972).

11. A wafer composite, comprising:
a layer stack (130) comprising a device layer (110) and an insulator layer (120), wherein the device layer (110) comprises electronic elements (315), and wherein the insulator layer (120) is in contact with a back surface (112) of the device layer (110);
an adhesive tape (155) on a side of the layer stack (130) opposite the device layer (110); and
a spacer disk (190) on a side of the adhesive tape (155) opposite the insulator layer (120), wherein lateral shape and dimension of the spacer disk (190) and the layer stack (130) are identical.

12. The wafer composite according to the preceding claim,
wherein a thickness th1 of the device layer (110) is at most 100nm, and wherein a sum of a thickness th3 of the layer stack (130) and a thickness th4 of the spacer disk (190) is at least 100µm.

13. A semiconductor device, comprising:
a device layer portion (910) comprising electronic elements (315) and a contact pad (916) formed on a contact side surface (911) of the device layer portion (910);
an insulator layer portion (920) in contact with a back surface (912) of the device layer portion (910);
an adhesive layer (950) on a side of the insulator layer portion (920) opposite the device layer portion (910); and
a spacer layer (990) on a side of the adhesive layer (950) opposite the insulator layer portion (920).

14. The semiconductor device according to the preceding claim,
wherein a thickness of the device layer portion (910) is at most 100nm and wherein a sum of a thickness of the device layer portion (910), a thickness of the insulator layer portion (920) and a thickness of the spacer layer (990) is at least 100µm.

15. The semiconductor device according to one of the two preceding claims, further comprising:
a device terminal (972) and a wiring connection (971) between the contact pad (916) and the device terminal (972) .
